(19) Europäisches Patentamt
European Patent Office
Office européen des brevets

(11) **EP 2 719 043 B1**

(12) **EUROPÄISCHE PATENTSCHRIFT**

(45) Veröffentlichungstag und Bekanntmachung des Hinweises auf die Patenterteilung:
**25.08.2021 Patentblatt 2021/34**

(51) Int Cl.:
*H02H 7/26* *(2006.01)*     *H02H 1/00* *(2006.01)*
*H02H 3/06* *(2006.01)*

(21) Anmeldenummer: **11767173.5**

(22) Anmeldetag: **21.07.2011**

(86) Internationale Anmeldenummer:
**PCT/EP2011/062524**

(87) Internationale Veröffentlichungsnummer:
**WO 2013/010591 (24.01.2013 Gazette 2013/04)**

(54) **FEHLERERKENNUNG UND -LOKALISIERUNG IN EINER EINSEITIG GESPEISTEN ENERGIEVERSORGUNGSLEITUNG**

FAULT IDENTIFICATION AND LOCATION IN A POWER SUPPLY LINE WHICH IS FED FROM ONE SIDE

DÉTECTION ET LOCALISATION DE DÉFAUTS DANS UNE LIGNE DE DISTRIBUTION D'ÉNERGIE ALIMENTÉE D'UN SEUL CÔTÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.04.2014 Patentblatt 2014/16**

(73) Patentinhaber: **Siemens Aktiengesellschaft 80333 München (DE)**

(72) Erfinder:
• **SCHUSTER, Norbert**
**26789 Leer (DE)**
• **SPANGLER, Markus**
**90542 Eckental (DE)**

(56) Entgegenhaltungen:
EP-A1- 1 443 624    EP-A2- 0 838 887
WO-A1-94/06189    WO-A1-2007/132551
WO-A2-00/48281    GB-A- 2 072 974
US-A1- 2007 025 036    US-B1- 7 110 231

• **KOCH G ET AL: "EIN NUMERISCHER STROMVERGLEICHSSCHUTZ MIT DIGITALER MESSWERTUEBERTRAGUNG UEBER LICHTWELLENLEITER", ELEKTRIE, VEB VERLAG TECHNIK. BERLIN, DD, Bd. 45, Nr. 7, 1. Januar 1991 (1991-01-01) , Seiten 272-276, XP000241404, ISSN: 0013-5399**
• **HEIKO ENGLERT ET AL: "IEC 61850 substation to control center communication - Status and practical experiences from projects", 2009 IEEE BUCHAREST POWERTECH, 1. Juni 2009 (2009-06-01), Seiten 1-6, XP55016074, DOI: 10.1109/PTC.2009.5281942 ISBN: 978-1-42-442234-0**

**Beschreibung**

Die Erfindung betrifft ein Verfahren zum Ermitteln eines fehlerbehafteten Abschnitts einer einseitig gespeisten Energieversorgungsleitung, die durch Schalteinrichtungen in mehrere Abschnitte unterteilt ist, wobei jeder Schalteinrichtung eine Messeinrichtung zugeordnet ist.

Elektrische Energieversorgungsnetze auf der Mittel- oder Niederspannungsebene werden dazu eingesetzt, elektrische Energie zu einzelnen Endverbrauchern zu übertragen. Seit der Liberalisierung der Energieversorgung werden in vielen Ländern vermehrt auch dezentrale Einspeisungen in das Energieversorgungsnetz vorgenommen. Bei solchen dezentralen Einspeisungen handelt es sich beispielsweise um sogenannte regenerative Energieerzeuger, also Energieerzeuger, die elektrische Energie aus kurzfristig erneuerbaren Energiequellen, wie z.B. Wind oder solarer Einstrahlung, bereitstellen. Solche Energieerzeuger können beispielsweise Windkraftanlagen oder Photovoltaikanlagen sein.

Energieversorgungsnetze auf der Mittel- und Niederspannungsebene umfassen häufig einseitig gespeiste Energieversorgungsleitungen, die zur effektiveren Überwachung in mehrere Abschnitte aufgeteilt sind. Eine solche Netzform wird im Gegensatz zu vermaschten Netzen auch als Strahlennetz bezeichnet. Dabei ist jeder Abschnitt an seinen Enden mittels Schalteinrichtungen begrenzt, die je nach ihrem Schaltvermögen in Form von Leistungsschaltern oder Trennschaltern ausgebildet sein können. Mit den einzelnen Abschnitten können einzelne Endverbraucher in Form von elektrischen Lasten oder Energieerzeuger in Form von Einspeisungen verbunden sein; dieser Aufbau ist insbesondere in von den USA geprägten Märkten üblich. Aber auch in westeuropäisch geprägten Märkten werden Energieversorgungsnetze mit solchen einseitig gespeisten Energieversorgungsleitungen verwendet, beispielsweise bei Kabelnetzen im unteren Mittelspannungsbereich (ca. 20kV).

Für Strahlenetze in der Mittel- und Niederspannung soll im Fall eines auf einem der Abschnitte einer Energieversorgungsleitung auftretenden Fehlers, insbesondere eines Kurzschlusses, innerhalb kurzer Zeit eine sichere Fehlererkennung und -lokalisierung stattfinden, d.h., der von dem Fehler betroffene Abschnitt muss schnell und zuverlässig erkannt und abgeschaltet werden.

Für die Fehlererkennung und -lokalisierung werden oft elektromechanische Kurzschlussanzeiger eingesetzt, die direkt an den jeweiligen Abschnitten der Energieversorgungsleitung angebracht werden. Diese sprechen nur bei hohen Kurzschlussströmen an, die deutlich über dem Nennstrom der Energieversorgungsleitung liegen. Meist erfolgt das Ablesen der Geräte manuell, d.h., der kurzschlussbehaftete Abschnitt wird oft erst nach relativ langer Zeit ermittelt. Ein solcher Kurzschlussanzeiger ist beispielsweise aus der deutschen Patentschrift DE 10 2007 020 955 B4 bekannt.

Aus der Europäischen Patentschrift EP 0 554 553 B1 ist zudem ein Verfahren bekannt, bei dem die Abschnitte einer Energieversorgungsleitung durch Schalteinrichtungen (sogenannte "Sectionalizer") voneinander begrenzt werden. Den Schalteinrichtungen ist jeweils eine Schutzeinrichtung zugeordnet. Die einzelnen Schutzeinrichtungen sind untereinander und mit einer Hauptschutzeinrichtung über eine Kommunikationsleitung verbunden. Ein Fehlerfall wird von der Hauptschutzeinrichtung erkannt. Diese sendet eine Anfrage an die einzelnen Schutzeinrichtungen, die anhand eines Spannungssignals überprüfen, ob auf dem ihnen zugeordneten Abschnitt ein Fehler vorliegt und eine entsprechende Antwort zurücksenden. Diejenigen Schutzeinrichtungen, die anhand der Antworten erkennen, dass sie einen fehlerfreien Abschnitt von einem fehlerbehafteten Abschnitt trennen, veranlassen ein Öffnen der Schaltkontakte der entsprechenden Schalteinrichtung.

Der Erfindung liegt die Aufgabe zugrunde, ein möglichst empfindliches und zuverlässiges Verfahren der eingangs angegebenen Art sowie eine ein solches Verfahren durchführende Messeinrichtung anzugeben.

Zur Lösung dieser Aufgabe wird erfindungsgemäß ein Verfahren gemäß Anspruch 1 vorgeschlagen.

Ein Vorteil des erfindungsgemäßen Verfahrens besteht darin, dass durch die Bildung der Deltastromwerte eine sehr empfindliche Fehlererkennung stattfinden kann, da Einflüsse von elektrischen Lasten oder von zu oder abfließenden Strömen außer Acht gelassen werden und ausschließlich der fehlerrelevante Anteil betrachtet wird. Damit lässt sich für das Verfahren eine Empfindlichkeit erzielen, die unterhalb des Nennstromes der Energieversorgungsleitung liegt, so dass sich auch hochohmige Fehler detektieren lassen.

Die zur Bildung des Deltastromwertes verwendete frühere Strommessgröße kann beispielsweise 2 oder 3 Perioden des Stromsignals vor der aktuellen Strommessgröße ermittelt worden sein. Die festgelegte Anzahl muss nicht ganzzahlig sein; oft empfiehlt sich jedoch die Wahl einer ganzzahligen Anzahl, um Schwebungseffekte zu vermeiden. Die Abtastung des Stromsignals erfolgt beispielsweise mit Taktraten zwischen 600Hz und 1kHz.

Die erste Statusnachricht kann beispielsweise eine Binärinformation umfassen, so dass zu ihrer Übertragung keine große Bandbreite einer Kommunikationsverbindung notwendig ist.

Das erfindungsgemäße Verfahren wird bei einer mehrphasigen Energieversorgungsleitung für jede Phase gesondert durchgeführt.

Eine vorteilhafte Ausführungsform des erfindungsgemäßen Verfahrens sieht vor, dass die Strommessgröße als Effektivwert oder als Grundschwingungsanteil aus den Stromabtastwerten ermittelt wird.

Diese Ausführungsform hat den Vorteil, dass zur Durchführung des erfindungsgemäßen Verfahrens lediglich die Stromsignale gemessen werden müssen, so dass in diesem Zusammenhang auf den Einsatz von teuren Spannungswandlern verzichtet werden kann. Die Berechnung der Deltastromgröße und die Fehlererkennung und -lokalisierung erfolgt dann ausschließlich mit den gemessenen Strömen.

Sind jedoch ohnehin Spannungswandler vorhanden oder sollen diese auch für andere Zwecke eingesetzt werden, so kann auch vorgesehen sein, dass die Strommessgröße aus den Stromabtastwerten und zugehörigen Spannungsabtastwerten berechnet wird. In diesem Fall kann es sich bei der Strommessgröße z.B. um eine elektrische Leistung (z.B. eine Wirkleistung oder eine Blindleistung) handeln.

Gemäß einer weiteren Ausführungsform des erfindungsgemäßen Verfahrens kann vorgesehen sein, dass der Stromschwellenwert statisch festgelegt wird.

Eine statische Festlegung hat den Vorteil, dass diese mit relativ wenigen Geräteeinstellungen auskommt und daher eine vergleichsweise einfache Geräteparametrierung erfolgen kann. Der statische Stromschwellenwert muss in diesem Fall derart festgelegt werden, dass Stromschwankungen aufgrund von Laständerungen oder Aufladevorgängen in dem jeweiligen Abschnitt nicht als Stromsprung gewertet werden. Geeignete Werte zur Einstellung des statischen Stromschwellenwertes liegen z.B. zwischen etwa 5% und 15% des für den jeweiligen Abschnitt gültigen Nennstromes.

Alternativ zur statischen Festlegung des Stromschwellenwertes kann gemäß einer anderen Ausführungsform des erfindungsgemäßen Verfahrens auch vorgesehen sein, dass der Stromschwellenwert dynamisch festgelegt wird.

Auf diese Weise kann der jeweilige verwendete Stromschwellenwert an die aktuelle Betriebssituation des jeweiligen Abschnittes angepasst werden.

Konkret kann in diesem Zusammenhang vorgesehen sein, dass der Stromschwellenwert dynamisch in Abhängigkeit von einem Differenzstromwert gebildet wird, der unter Verwendung einer Differenz zwischen den an beiden Enden eines Abschnitts der Energieversorgungsleitung ermittelten Strommessgrößen gebildet wird.

Hierdurch findet quasi an den beiden Enden eines Abschnitts eine Messung der Lastströme und Einspeisungen im Normalbetrieb statt, so dass während des Betriebes eine adaptive Anpassung der Ansprechempfindlichkeit (z.B. an sich moderat verändernde Last- bzw. Einspeiseverhältnisse) erfolgen kann. Um nicht unbeabsichtigt eine adaptive Anpassung an eine Fehlersituation auf dem jeweiligen Abschnitt vorzunehmen, sollten zur Bildung des Differenzstromwertes solche Strommessgrößen herangezogen werden, bei denen kein Stromsprung erkannt worden ist.

Gemäß einer weiteren vorteilhaften Ausführungsform des erfindungsgemäßen Verfahrens kann zudem vorgesehen sein, dass zur Bildung des Deltastromwertes anstelle der früheren Strommessgröße ein festgelegter Maximalwert verwendet wird, wenn die frühere Strommessgröße einen vorgegebenen Vergleichsschwellenwert übersteigt.

Hierdurch kann vorteilhaft eine ungewollte Stromsprungerkennung der Messeinrichtungen im Falle einer Wandlersättigung während eines Fehlers vermieden werden.

Der Vergleichsschwellenwert kann beispielsweise in Abhängigkeit von einem Differenzstromwert gebildet werden, der unter Verwendung einer Differenz zwischen den an beiden Enden eines Abschnitts der Energieversorgungsleitung ermittelten Strommessgrößen gebildet wird.

Konkret kann der Vergleichsschwellenwert beispielsweise unter Verwendung des Differenzstroms und des Nennstroms gemäß folgender Gleichung gebildet werden:

$$I_V = I_{N,i} + I_{Diff,i} \, ,$$

wobei $I_V$ den Vergleichsschwellenwert, $I_{N,i}$ den an der Messstelle i gültigen Nennstrom und $I_{Diff,i}$ den an der Messstelle i gebildeten Differenzstromwert angeben.

Eine weitere vorteilhafte Ausführungsform des erfindungsgemäßen Verfahrens sieht vor, dass die Fehlerlokalisierungseinrichtung Bestandteil zumindest einer der Messeinrichtungen ist.

In diesem Fall wird die Erkennung und Lokalisierung eines Fehlers durch eine oder mehrere Messeinrichtungen selbst durchgeführt.

Alternativ kann jedoch auch vorgesehen sein, dass die Fehlerlokalisierungseinrichtung Bestandteil einer von den Messeinrichtungen verschiedenen zentralen Auswertungseinrichtung ist.

Diese Auswertungseinrichtung kann beispielsweise eine separate Einrichtung sein, in einem an der Einspeisung der Energieversorgungsleitung vorgesehenen Schutzgerät integriert oder Bestandteil einer Netzleittechnik, z.B. eines SCADA-Systems (SCADA = Supervisory Control and Data Acquisition), sein.

Eine weitere vorteilhafte Ausführungsform des erfindungsgemäßen Verfahrens sieht vor, dass die Messeinrichtungen, solange sie keinen Stromsprung erkennen, in regelmäßigen Zeitabständen eine zweite Statusnachricht versenden, die angibt, dass kein Stromsprung erkannt wurde, und dass die Messeinrichtungen die erste Statusnachricht in solchen Zeitabständen wiederholen, die kleiner als die Zeitabstände sind, in denen die zweite Statusnachricht versendet wird.

Die zweite Statusnachricht stellt in diesem Fall eine zyklische Nachricht dar, die regelmäßig einen normalen Betriebszustand des jeweiligen Abschnittes meldet. Die hierfür verwendeten Zeitabstände können beispielsweise im Sekundenabstand liegen (z.B. zwischen ca. 1-10 Sekunden). Die erste Statusnachricht stellt hingegen eine spontane Nachricht dar, die sofort bei Erkennung eines Stromsprungs abgesetzt und in sehr kurzen Zeitabständen (z.B. im Abstand weniger Millisekunden) wiederholt wird. Auf diese Weise kann einerseits die Funktionsfähigkeit der Kommunikationsverbindung zwischen den einzelnen Messeinrichtungen und der Fehlerlokalisierungseinrichtung anhand der ordnungsgemäß empfangenen zweiten Statusnachrichten geprüft werden und andererseits sichergestellt werden, dass unmittelbar bei Erkennung eines Stromsprungs, der auf einen Fehler hindeuten könnte, die erste Statusnachricht erzeugt wird. Durch die häufige Wiederholung der ersten Statusnachricht kann sichergestellt werden, dass die Information über den Stromsprung sicher beim Empfänger ankommt und nicht durch einzelne Telegrammverluste auf der Kommunikationsverbindung verlorengeht.

Beispielsweise kann vorgesehen sein, dass die Statusnachrichten als Broadcast-Nachrichten oder Multicast-Nachrichten versendet werden. Hiermit wird erreicht, dass die in den Statusnachrichten enthaltene Information nicht nur einem Empfänger, sondern allen (Broadcast) oder mehreren Empfängern (Multicast) nahezu gleichzeitig übermittelt wird.

Die Statusnachrichten können über beliebige Verfahren übertragen werden. Im einfachsten Fall können hierzu Binärsignale an eine Kupferleitung ("Pilot Wire") angelegt werden. Außerdem kommen verschiedenste Übertragungsprotokolle, wie z.B. DNP 3, (Distributed Network Protocol) oder Leittechnikprotokolle, wie z.B. Modbus, in Frage.

Gemäß einer besonders vorteilhaften Ausführungsform kann beispielsweise vorgesehen sein, dass die Statusnachrichten als GOOSE-Nachrichten gemäß dem Standard IEC 61850 gebildet werden.

Diese GOOSE-Nachrichten (Generic Object Oriented Substation Event) sind im Standard IEC 61850, der insbesondere die Kommunikation in elektrischen Schaltanlagen regelt, beschrieben und eignen sich besonders zur sehr schnellen Übertragung kurzer (insbesondere binärer) Inhalte.

Für die Übertragung der ersten Statusnachrichten, z.B. über GOOSE-Nachrichten der IEC 61850, ist gemäß einer weiteren Ausführungsform des erfindungsgemäßen Verfahrens keine exakte Zeitsynchronisation notwendig. Es ist ausreichend, die maximale Laufzeit über das Kommunikationsnetz zu berücksichtigen. Gemäß der Erfindung ist vorgesehen, dass die Fehlerlokalisierungseinrichtung einen Fehler als auf einem bestimmten Abschnitt der Energieversorgungsleitung liegend erkennt, wenn innerhalb einer maximalen Zeitdauer nach Erkennen eines Stromsprungs mit der Messeinrichtung an dem einen Ende des Abschnitts eine erste Statusnachricht der Messeinrichtung an dem zweiten Ende des Abschnitts ausbleibt.

Die maximale Zeitdauer kann beispielsweise die Übertragungszeit zwischen der jeweiligen Messeinrichtung und der Fehlerlokalisierungseinrichtung sowie eine Zeitreserve für die nichtsynchrone Abtastung des Stromsignals an der jeweiligen Messstelle berücksichtigen.

Um die Sicherheit gegen Fehlentscheidungen weiter zu erhöhen, kann gemäß einer weiteren vorteilhaften Ausführungsform des erfindungsgemäßen Verfahrens vorgesehen sein, dass die Fehlerlokalisierungseinrichtung erst dann einen Fehler als auf dem bestimmten Abschnitt liegend erkennt, wenn der Deltastromwert derjenigen Messeinrichtung, die den Stromsprung erkannt hat, über einem Bestätigungsschwellenwert liegt, der in Abhängigkeit von einem Differenzstromwert gebildet wird, der unter Verwendung einer Differenz zwischen den an beiden Enden eines Abschnitts der Energieversorgungsleitung ermittelten aktuellen Strommessgrößen gebildet wird.

Hierdurch kann insbesondere bei hinsichtlich der Erkennung eines Stromsprungs relativ klein gewählten Stromschwellenwerten eine weitere Bedingung zur Erkennung eines tatsächlich vorliegenden Fehlers vorgesehen werden.

Wenn die Schalteinrichtungen an den einzelnen Abschnitten zur Abschaltung von Fehlerströmen geeignete Leistungsschalter sind, kann gemäß einer weiteren vorteilhaften Ausführungsform des erfindungsgemäßen Verfahrens vorgesehen sein, dass bei einem auf einem bestimmten Abschnitt der Energieversorgungsleitung erkannten Fehler unmittelbar diejenigen Schalteinrichtungen geöffnet werden, die diesen Abschnitt der Energieversorgungsleitung begrenzen.

Alternativ dazu kann auch vorgesehen sein, dass bei einem auf einem bestimmten Abschnitt der Energieversorgungsleitung erkannten Fehler zunächst ein den Schalteinrichtungen einspeiseseitig vorgeordneter Leistungsschalter geöffnet wird und erst nach dem Öffnen des Leistungsschalters diejenigen Schalteinrichtungen geöffnet werden, die diesen Abschnitt der Energieversorgungsleitung begrenzen.

Bei dieser Alternative können die Schalteinrichtungen an den Abschnitten im Vergleich zu einem Leistungsschalter kostengünstigere Trennschalter mit relativ geringer Schaltleistung sein, da der Fehlerstrom durch den einspeiseseitig vorgesehenen Leistungsschalter, der gleichsam einen Hauptschalter für die Energieversorgungsleitung bildet, abgeschaltet wird.

In diesem Zusammenhang kann zudem vorgesehen sein, dass nach dem Öffnen der den fehlerbehafteten Abschnitt begrenzenden Schalteinrichtungen der Leistungsschalter wieder geschlossen wird.

Auf diese Weise kann die Energieversorgung für die Endverbraucher bis zum fehlerbehafteten Abschnitt zeitnah wiederhergestellt werden.

Um auch für die hinter dem fehlerbehafteten Abschnitt liegenden Lasten eine möglichst schnelle Wiederherstellung der Energieversorgung zu ermöglichen, kann in diesem Zusammenhang außerdem vorgesehen sein, dass nach dem Öffnen der den fehlerbehafteten Abschnitt begrenzenden Schalteinrichtungen auch ein Verbindungsschalter geschlossen wird, der denjenigen Teil der Energieversorgungsleitung, der an das von der Einspeisung abgewandte Ende des fehlerbehafteten Abschnitts angrenzt, mit einer weiteren Einspeisung verbindet.

Hierdurch können diejenigen Lasten und Einspeisungen, die an nicht von dem Fehler betroffenen Abschnitten angeordnet sind, zeitnah wieder mit elektrischer Energie versorgt werden.

Die oben genannte Aufgabe wird auch durch eine Messeinrichtung zum Ermitteln eines fehlerbehafteten Abschnitts einer einseitig gespeisten Energieversorgungsleitung gelöst, wobei die Energieversorgungsleitung durch Schalteinrichtungen in mehrere Abschnitte unterteilt ist und wobei die Messeinrichtung einer der Schalteinrichtungen zuordenbar ist.

Erfindungsgemäß ist vorgesehen, dass die Messeinrichtung zur Durchführung eines Verfahrens gemäß einem der Ansprüche 1 bis 17 eingerichtet ist.

Mehrere solcher Messeinrichtungen bilden gemeinsam mit einer Fehlerlokalisierungseinrichtung ein System zum Ermitteln eines fehlerbehafteten Abschnitts einer einseitig gespeisten Energieversorgungsleitung. Die Fehlerlokalisierungseinrichtung kann dabei Bestandteil einer der Messeinrichtungen sein, als separates Gerät ausgeführt oder in eine übergeordnete Schutz- oder Steuereinrichtung integriert sein.

Im Folgenden soll die Erfindung anhand von Ausführungsbeispielen näher erläutert werden. Hierzu zeigen

Figur 1    eine schematische Ansicht einer ersten Ausführungsform eines elektrischen Energieversorgungsnetzes mit zwei einseitig gespeisten Energieversorgungsleitungen;

Figur 2    eine schematische Ansicht einer zweiten Ausführungsform eines elektrischen Energieversorgungsnetzes mit einer zentralen Fehlerlokalisierungseinrichtung.

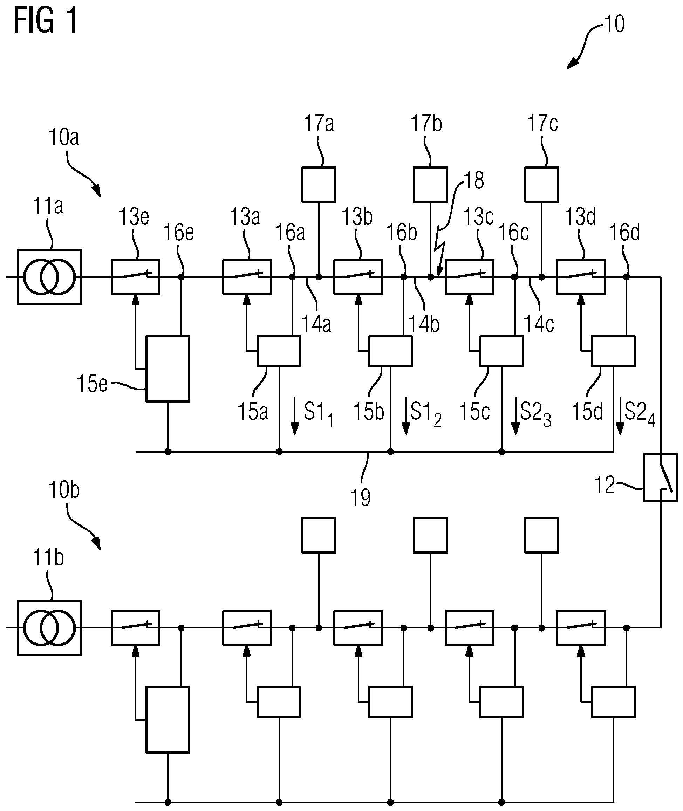

Figur 1 zeigt in schematischer Darstellung einen Teil eines elektrischen Energieversorgungsnetzes 10, bei dem es sich beispielsweise um eine Mittelspannungsverteilnetz handeln kann. Das Energieversorgungsnetz 10 umfasst eine erste Energieversorgungsleitung 10a und eine zweite Energieversorgungsleitung 10b. Die Energieversorgungsleitungen 10a, 10b sind von Transformatoren 11a, 11b einseitig mit elektrischer Energie gespeist. Die Speisung der Transformatoren auf der Primärseite kann durch eine oder mehrere Quellen erfolgen. An ihrem von der Einspeisung abgewandten Ende sind die Energieversorgungsleitungen 10a, 10b mittels eines üblicherweise offenen Verbindungsschalters 12 in bestimmten Fällen miteinander koppelbar. Hierauf wird später näher eingegangen.

Bei dem Ausführungsbeispiel gemäß Figur 1 entspricht sich der Einfachheit halber der Aufbau der beiden Energieversorgungsleitungen 10a und 10b, so dass die folgenden Ausführungen außer an explizit genannten Stellen anhand der Energieversorgungsleitung 10a stellvertretend für beide Energieversorgungsleitungen 10a und 10b gemacht werden.

Die Energieversorgungsleitung 10a ist mittels Schalteinrichtungen 13a-d in mehrere Abschnitte 14a-c unterteilt. Jeder Abschnitt 14a-c wird hierbei von zwei der Schalteinrichtungen 13a-d begrenzt. Bei den Schalteinrichtungen 13a-d kann es sich je nach Schaltvermögen um Trennschalter oder um Leistungsschalter handeln. Einspeiseseitig ist ein Leistungsschalter 13e vorgesehen, der die gesamte Energieversorgungsleitung 10a von der Einspeisung durch den Transformator 11a abtrennen kann und damit quasi als Hauptschalter für die Energieversorgungsleitung 10a dient.

Den einzelnen Schalteinrichtungen 13a-d sind Messeinrichtungen 15a-d zugeordnet. Diese nehmen an in der Nähe der jeweiligen Schalteinrichtungen 13a-d angeordneten Messstellen 16a-d Stromsignale auf, die den in der Energieversorgungsleitung an der jeweiligen Messstelle 16a-d fließenden Strom angeben. Dem Leistungsschalter 13e ist ein Schutzgerät 15e zugeordnet.

Mit jedem Abschnitt 14a-c der Energieversorgungsleitung 10a können elektrische Verbraucher in Form von Lasten oder elektrische Energieerzeuger in Form von Quellen verbunden sein. Beispielhaft sind in Figur 1 Lasten 17a und 17b sowie eine Quelle 17c gezeigt, die mit den Abschnitten 14a-c verbunden sind.

Die einzelnen Messeinrichtungen 15a-d sind über eine Kommunikationsverbindung 19 miteinander verbunden, so dass zwischen den Messeinrichtungen 15a-d Informationen ausgetauscht werden können. Das Schutzgerät 15e ist ebenfalls mit der Kommunikationsverbindung 19 verbunden. Die Kommunikationsverbindung kann dabei beliebig ausgeführt sein; im einfachsten Fall kann es sich um eine Kupferleitung ("Pilot Wire") handeln, über das elektrische Signale übertragen werden können. Daneben können aber auch komplexere Kommunikationsverbindungen, insbesondere ein Kommunikationsbus, beispielsweise auf Ethernetbasis, zum Einsatz kommen.

Das Energieversorgungsnetz 10 ist in der Figur 1 in der sogenannten "Single-Line-Ansicht" dargestellt, bei der lediglich eine Phase des Energieversorgungsnetzes gezeigt ist. Tatsächlich handelt es sich bei dem Energieversorgungsnetz 10 üblicherweise um ein mehrphasiges (z.B. dreiphasiges) Netz. Das im folgenden beschriebene Verfahren wird daher für jede der vorhandenen Phasen entsprechend durchgeführt.

Wenn auf einem Abschnitt ein Fehler, beispielsweise ein Kurzschluss auftritt, sind einerseits der Fehler möglichst schnell zu erkennen und der Fehlerstrom abzuschalten. Andererseits muss der von dem Fehler betroffene Abschnitt der Energieversorgungsleitung erkannt und isoliert werden, damit die gesunden Abschnitte möglichst schnell wieder mit elektrischer Energie versorgt werden können.

Im Folgenden soll am Beispiel eines auf dem Abschnitt 14b liegenden Kurzschlusses 18 ein Verfahren zur Ermittlung eines fehlerbehafteten Abschnitts erläutert werden.

Jede Messeinrichtung erfasst über an den Messstellen 16a-d angeordnete Stromwandler ein Stromsignal für jede Phase. Das erfasste Stromsignal wird von einer Abtasteinrichtung unter Bildung von phasenbezogenen Stromabtastwerten abgetastet. Eine solche Abtastung kann beispielsweise mit einer Abtatsrate von 600Hz-1kHz stattfinden. Aus den Abtastwerten wird mit einer Recheneinrichtung (z.B. einem digitalen Signalprozessor (DSP) oder einer zentralen Recheneinheit (CPU) der Messeinrichtung) eine Strommessgröße ermittelt. Die Strommessgröße kann hierbei beispielsweise ein Effektivwert oder ein Betrag der Grundschwingung (z.B. für den 50Hz-Anteil des Stromsignals) sein. Den Betrag der Grundschwingung erhält durch digitale Filterung aus den Stromabtastwerten, wobei ein entsprechend auf die Grundschwingung angepasstes Filter einen Sinusanteil der Abtastwerte und ein weiteres auf die Grundschwingung angepasstes Filter einen Kosinusanteil der Abtastwerte bestimmt. Zur Bildung des Betrags der Grundschwingung wird die Wurzel aus der Summe der quadrierten Anteile (Sinus und Kosinus) bestimmt. Sollen bei der Strommessgröße harmonische Oberschwingungen unterdrückt werden, die z.B. durch Einschalten von Transformatoren zwischen den Messstellen 16a-d entstehen, wird die der Betrag der Grundschwingung verwendet. Wenn harmonische Oberschwingungen bei der Strommessgröße mit bewertet werden sollen, so kann dies durch Bildung des Effektivwertes erreicht werden. Generell kann beim Auftreten starker Anteile von Oberschwingungen eine Schutzfunktion in den Messeinrichtungen 15a-d und/oder dem Schutzgerät 15e vorübergehend kurz unterdrückt werden. Der Vorteil bei der Verwendung des Effektivwertes oder des Betrags der Grundschwingung liegt darin, dass hierfür außer der Erfassung des Stromsignals keine weiteren Messungen durchgeführt werden müssen, so dass lediglich Stormwandler benötigt werden. Sind jedoch bereits Spannungswandler vorhanden oder werden für andere Zwecke zusätzlich Spannungswandler benötigt, so kann die Strommessgröße auch aus einer rechnerischen Verknüpfung von Stromabtastwerten und zugehörigen Spannungsabtastwerten gebildet werden (z.B. in Form einer Wirk- oder Blindleistung). Die Art und Weise, wie die Strommessgröße gebildet werden soll, kann durch entsprechende Parametrierung der Messgeräte durch den Betreiber des Energieversorgungsnetzes ausgewählt werden.

Die Ermittlung der Strommessgröße liefert in jeder Messeinrichtung den Wert $I_j(t)$, wobei j die jeweilige Messeinrichtung bezeichnet (z.B. wird die Strommessgröße $I_2(t)$ von der zweiten Messeinrichtung 15b der Energieversorgungsleitung 10a gebildet). Betrachtet wird hier der Einfachheit halber nur eine Phase. Real findet die Messung des Stromsignals und Berechnung der Strommessgröße wie bereits erwähnt für alle Phasen der Energieversorgungsleitung 10a statt und wird fortwährend für alle Messstellen durchgeführt.

Der aktuell berechnete Wert der Strommessgröße wird von einer früheren Strommessgröße subtrahiert, so dass sich als Differenz eine Deltastromgröße $DI_j(t)$ ergibt. Die frühere Strommessgröße wurde bereits einige (z.B. 2 - 3) Perioden (N) des Stromsignals früher gebildet und in der jeweiligen Messeinrichtung, z.B. in einem Ringspeicher, abgespeichert. Die frühere Strommessgröße muss nicht unbedingt eine ganzzahlige Anzahl von Perioden des Stromsignals früher ermittelt worden sein, jedoch bietet sich zur Vermeidung von Schwebungseffekten die Verwendung einer ganzzahligen Anzahl an. Die Deltastromgröße wird beispielsweise bei der Verwendung einer vor zwei Perioden (N) gebildeten früheren Strommessgröße gemäß folgender Gleichung ermittelt:

$$DI_j(t) \; = \; I_j(t) - I_j(t-2N).$$

Die Deltastromgröße $DI_j(t)$ hat im stabilen Betrieb einen Wert von Nahe Null, da dann keine Stromänderung auf dem jeweiligen Abschnitt 14a-c der Energieversorgungsleitung 10a auftritt.

In jeder Messeinrichtung 15a-d wird der jeweilige Deltastromwert mit einem Stromschwellenwert $S_I$ verglichen und es wird ein Stromsprung auf dem jeweiligen Abschnitt erkannt, wenn der Deltastromwert oberhalb des Stromschwellenwertes liegt. Ein Stromsprung wird hierbei als eine positive Stromänderung einer bestimmten Mindestgröße verstanden. Die Messeinrichtungen 15a-d versenden unmittelbar nach der Erkennung des Stromsprungs erste Statusnachrichten $S1_j$, die einen erkannten Stromsprung an der Messstelle j angeben, über die Kommunikationsverbindung 19. Diese ersten Statusnachrichten $S1_j$ können beispielsweise einfache Binärsignale (Low, High) sein. In einer bevorzugten Ausführungsform werden solche Binärsignale als Multicast-Nachrichten in Form von sogenannten GOOSE-Nachrichten gemäß dem Standard IEC 61850 übertragen.

Bei dem Beispiel in Figur 1 fließt durch an der Kurzschlussstelle 18 ein Fehlerstrom $I_F$, der durch den Transformator 11a gespeist wird. Das Schutzgerät 15e erkennt einen Stromsprung. Ebenso erkennen die Messeinrichtungen 15a und 15b einen Stromsprung und senden erste Statusnachrichten $S1_1$ und $S1_2$ aus. Die übrigen Messeinrichtungen 15c und 15d erkennen hingegen keinen Stromsprung (z.B. da der fließende Strom gleich bleibt oder sogar absinkt) und senden keine ersten Statusnachrichten aus. Stattdessen kann vorgesehen sein, dass alle Messeinrichtungen, die keinen Stromsprung erkennen, in regelmäßigen Abständen, also zyklisch, eine zweite Statusnachricht $S2_j$ aussenden, wobei die Zeitabstände, in denen eine solche zweite Statusnachricht ausgesandt werden, beispielsweise wenige Sekunden betragen können. Insbesondere wenn es sich bei den Statusnachrichten um GOOSE-Nachrichten handelt, wird auch die erste Statusnachricht S1$_j$ wiederholt ausgesendet, wobei der Zeitabstand, in dem die ersten Statusnachrichten wiederholt werden, viel geringer ist (z.B. wenige Millisekunden), als der für die zweiten Statusnachrichten verwendete Zeitabstand.

Als Stromschwellenwert S$_l$ zur Bewertung des Deltastromwertes kann beispielsweise ein statischer Wert verwendet werden, dieser kann z.B. bei ca. 5%-15% des für den jeweiligen Abschnitt 14a-c geltenden Nennstromes I$_N$ eingestellt werden (d.h. bei einem Stromschwellenwert von 5% des Nennstromes erzeugen Änderungen des Deltastromwertes kleiner als 5% des Nennstromes keine Stromsprungserkennung). Konstante Werte des Deltastromes, geringe Stromänderungen, ein Lastabfall oder das Abschalten eines externen Kurzschlussstromes lösen hierbei keine Stromsprungerkennung aus.

Der Stromschwellenwert kann jedoch auch dynamisch bestimmt und an die Höhe eines Differenzstromwertes (z.B. 25% des Differenzstromwertes) angepasst werden, der unter Verwendung des Betrags der Differenz der Stromabtastwerte zwischen benachbarten Messeinrichtungen bestimmt wird. Konkret kann der Differenzstromwert beispielsweise nach folgender Gleichung gebildet werden:

$$I_{Diff,j} = I_{korr} + k * |(I_j - I_{j+1})|.$$

I$_{korr}$ ist hierbei ein Korrekturwert für den jeweiligen Abschnitt, der Fehler bei der Bestimmung der Stromabtastwerte (z.B. durch Ladeströme, Wandlerfehler usw.) ausgleichen soll. Der Sicherheitsfaktor k beeinflusst die Empfindlichkeit, d.h. bei höheren k-Werten wird der als Stromschwellenwert für den Deltastromwert verwendete Differenzstromwert erhöht und das Verfahren zur Erkennung eines Stromsprungs damit unempfindlicher (der Sicherheitsfaktor kann beispielsweise Werte k=1...1,2 annehmen). Zur Bestimmung des Differenzstromwertes müssen die jeweiligen Strommessgrößen I$_j$ zwischen den Messeinrichtungen 15a-d pro Phase ausgetauscht werden. Dies erfolgt z.B. im Abstand von einer Sekunde und nur solange die Deltastromwerte annähernd Null sind, per GOOSE-Nachricht über das Kommunikationsnetz. Die Wahl eines dynamischen Schwellenwertes hat den Vorteil, dass auf dem Abschnitt 14a-c ab- bzw. zufließende Ströme durch Lasten bzw. Quellen in dem Differenzstromwert berücksichtigt werden. Sind keine Lasten bzw. Quellen vorhanden, hat das Verfahren die maximale Empfindlichkeit.

Die ersten Statusnachrichten S1$_j$ werden an eine Fehlerlokalisierungseinrichtung übertragen, die beispielsweise Bestandteil einer Messeinrichtung (oder aller Messeinrichtungen) oder in das Schutzgerät 15e integriert sein kann. In dem Schutzgerät kann sie z.B. mit der dortigen Auslösebedingung verknüpft werden (z.B. Überstromschutz oder Distanzschutz). Die Fehlerlokalisierungseinrichtung erkennt den Kurzschluss als auf demjenigen Abschnitt liegend, der von solchen Messeinrichtungen begrenzt wird, von denen eine einen Stromsprung erkannt hat und die andere keinen Stromsprung erkannt hat. Im Fall der Figur 1 erkennt die Messeinrichtung 15b einen Stromsprung, während die Messeinrichtung 15c keinen Stromsprung erkennt. Dies kann von der Fehlerlokalisierungseinrichtung anhand des Vorliegens oder Fehlens der jeweiligen ersten Statusnachricht erkannt werden. In diesem Fall erkennt die Fehlerlokalisierungseinrichtung folglich den Kurzschluss auf dem Abschnitt 14b.

Handelt es sich bei den Schalteinrichtungen 13a-d um Leistungsschalter, die zur Abschaltung von Kurzschlussströmen geeignet sind, so können daraufhin unmittelbar diejenigen Schalteinrichtungen 13b und 13c geöffnet werden, die den fehlerbehafteten Abschnitt 14b der Energieversorgungsleitung 10a begrenzen. Dies kann entweder von den Messeinrichtungen 15b und 15c selbst veranlasst werden oder durch das Schutzgerät 15e mittels entsprechender Auslösekommandos ausgelöst werden.

Handelt es sich bei den Schalteinrichtungen 13a-d lediglich um Trennschalter mit geringerem Schaltvermögen, so wird nach der Lokalisierung des Fehlers auf dem Abschnitt 14b zunächst der den Schalteinrichtungen 13a-d einspeiseseitig vorgeordneter Leistungsschalter 13e geöffnet. Hierdurch fällt die Stromsprungerkennung in den Messeinrichtungen 15a und 15b und damit die Bildung der ersten Statusnachricht zurück, wenn der Strom an allen Messstellen 16a-d auf der durch den Leistungsschalter 13e abgeschalteten Energieversorgungsleitung 10a unter den Stromschwellenwert absinkt. Erst nach dem Öffnen des Leistungsschalters 13e werden die Schalteinrichtungen 13b und 13c geöffnet, die den Abschnitt 14b begrenzen, indem die Schalteinrichtungen 13b und 13c zum Öffnen veranlasst werden. Dies kann durch die Messeinrichtungen 15b und 15c selbst geschehen. Alternativ wird die Öffnung der Schalteinrichtungen 13b und 13c durch die Leistungsschaltersteuerung bzw. das Schutzgerät 15e herbeigeführt. Mit der Rückmeldung der Schalteinrichtungen, dass der offene Zustand herrscht, kann der Leistungsschalter 13e wieder geschlossen werden. Nach dem Öffnen der den fehlerbehafteten Abschnitt 14b begrenzenden Schalteinrichtungen 13b und 13c kann der Verbindungsschalter 12 geschlossen werden, der denjenigen Teil der Energieversorgungsleitung 10a, der an das von der Einspeisung abgewandte Ende des fehlerbehafteten Abschnitts 14b angrenzt, also den Abschnitt 14c, mit der zweiten Energieversorgungsleitung 10b verbindet, so dass eine Energieversorgung für diesen gesunden Abschnitt 14c wiederhergestellt werden kann.

Um den Deltastromwert noch zuverlässiger bilden zu können und Einflüsse durch ggf. während eines Kurzschlusses auftretende Wandlersättigungen zu vermeiden, kann zudem vorgesehen sein, dass zur Bildung des Deltastromwertes anstelle der früheren Strommessgröße ein festgelegter Maximalwert verwendet wird, wenn die frühere Strommessgröße einen vorgegebenen Vergleichsschwellenwert übersteigt. Der Vergleichsschwellenwert $I_{Vgl}$ kann hierbei beispielsweise auch an den Differenzstromwert angepasst werden und außerdem noch den für die jeweilige Messstelle geltenden Nennstrom berücksichtigen:

$$I_{Vgl,j} = I_{N,j} + I_{Diff,j}.$$

Der Maximalwert kann dabei ebenfalls die Größe des Vergleichsschwellenwertes annehmen. Damit wird für größere Ströme (insbesondere Kurzschlussströme) der Deltastromwert aus der Differenz der aktuell berechneten Strommessgröße und dem konstanten Wert des Vergleichsschwellenwertes $I_{Vgl}$ gebildet. Dies verhindert, dass der zu bewertende Deltastromwert nach einer gewissen Anzahl von Perioden zu Null wird und durch spätere Sättigung eines Stromwandlers es zu einer Überfunktion durch einen dadurch erzeugten Deltastrom kommt. Während eines Kurzschlusses wird so der durchfließende Strom auf den kurzschlussrelevanten Anteil begrenzt.

Die Fehlerlokalisierung durch die Fehlerlokalisierungseinrichtung kann beispielsweise dadurch unterstützt werden, dass den ersten Statusnachrichten $S1_j$ der jeweiligen Messeinrichtungen 15a-d Zeitstempel zugeordnet werden und die Abtastung der Stromsignale in den Messeinrichtungen 15a-d synchronisiert erfolgt. Besonders einfach kann das vorgehend beschriebene Verfahren aber auch mit nicht synchronisiert arbeitenden Messeinrichtungen 15a-d durchgeführt werden, weil erfindungsgemäß die Fehlerlokalisierungseinrichtung einen Fehler als auf einem bestimmten Abschnitt der Energieversorgungsleitung liegend erkennt, wenn innerhalb einer maximalen Zeitdauer nach Erkennen eines Stromsprungs mit der Messeinrichtung 15b an dem einen Ende des Abschnitts 14b eine erste Statusnachricht $S1_3$ der Messeinrichtung 15c an dem zweiten Ende des Abschnitts 14b ausbleibt. Hierbei wird vorausgesetzt, dass die Messeinrichtungen 15a-d unmittelbar nach der Erkennung eines Stromsprungs eine erste Statusnachricht $S1_j$ absenden. Die maximale Zeitdauer umfasst daher die maximale Übertragungszeit von den jeweiligen Messeinrichtungen 15a-d zur Fehlerlokalisierungseinrichtung zuzüglich einer Reservezeitdauer für die nichtsynchrone Durchführung der Stromsprungerkennung in den einzelnen Messeinrichtungen. Die maximale Übertragungszeitdauer entspricht der doppelten mittleren Übertragungszeit zwischen der jeweiligen Messeinrichtung 15a-d und der Fehlerlokalisierungseinrichtung bzw. der Übertragungszeit, die eine Nachricht für die Hin- und Rückübertragung benötigt. Dies kann durch einfache Zeitstempelungen von Testnachrichten gemessen werden.

Um mit dem Verfahren noch zuverlässiger Stromsprünge aufgrund von größeren Laständerungen (z.B. dem Zuschalten eines elektrischen Verbrauchers großer Leistung) von Stromsprüngen aufgrund von Kurzschlüssen unterscheiden zu können, kann außerdem vorgesehen sein, dass die Fehlerlokalisierungseinrichtung erst dann einen Fehler als auf dem bestimmten Abschnitt liegend erkennt, wenn der Deltastromwert derjenigen Messeinrichtung, die den Stromsprung erkannt hat (hier Messeinrichtung 15b), über einem Bestätigungsschwellenwert liegt, der in Abhängigkeit von dem Differenzstromwert gebildet wird. Der Differenzstromwert passt sich adaptiv langsameren Laständerungen an, so dass durch diese zusätzliche Plausibilitätsprüfung ein Stromsprung besser als zu einer Last oder zu einem Fehler gehörig klassifiziert werden kann. Die Überprüfung der Höhe des Deltastromwertes kann entweder durch die Fehlerlokalisierungseinrichtung durchgeführt werden, oder durch die jeweilige Messeinrichtung selbst erfolgen. Im letztgenannten Fall wird das Versenden der ersten Statusnachricht bei Nichterfüllung dieser Plausibilitätsbedingung durch die jeweilige Messeinrichtung unterdrückt.

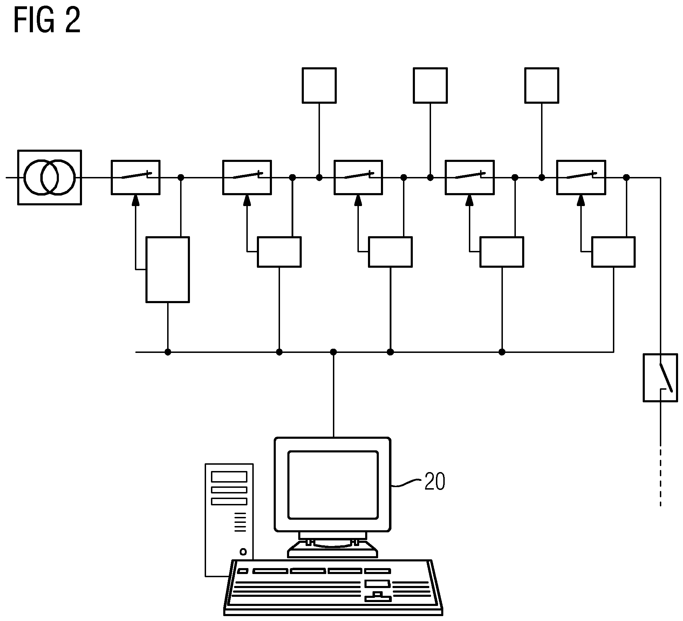

Figur 2 zeigt schließlich ein Ausführungsbeispiel eines Energieversorgungsnetzes, bei dem sich lediglich die Lage der Fehlerlokalisierungseinrichtung von der Situation in Figur 1 unterscheidet. Anstelle in einer der Messeinrichtungen oder in dem Schutzgerät ist die Fehlerlokalisierungseinrichtung gemäß Figur 2 in einer Datenverarbeitungseinrichtung 20 einer Netzleitstelle (z.B. einem SCADA-System) integriert, die den Betrieb des Energieversorgungsnetzes steuert und überwacht. Ansonsten kommt bei der Fehlererkennung und -lokalisierung die bereits zu Figur 1 beschriebenen Vorgehensweise zur Anwendung, so dass hierauf nicht noch einmal gesondert eingegangen werden soll.

Zusammenfassend wurde voranstehend ein Verfahren beschrieben, das eine Fehlererkennung und -lokalisierung in einseitig gespeisten Energieversorgungsleitungen ermöglicht. Die Fehlererkennung und -lokalisierung ist robust gegenüber Einspeisungen oder Verbrauchern auf den Abschnitten der Energieversorgungsleitung und wird durch ein empfindliches Strommessverfahren erzielt, das in den Messgeräten durchgeführt wird, die den jeweiligen Leitungsabschnitt überwachen. Prinzipiell werden nur die über Stromwandler gemessenen Ströme benötigt, so dass keine teuren Spannungswandler vorgesehen werden müssen (bei vorhandenen Spannungswandlern kann das Spannungssignal jedoch auch hinzugezogen werden). Das Verfahren zeichnet sich dadurch aus, dass nur wenige, meist binäre, Größen übertragen werden, die z.B. in Form einer GOOSE-Nachricht gemäß der IEC 61850 gebildet werden können.

Der fehlerbehaftete Leitungsabschnitt kann durch Öffnen der ihn begrenzenden Schalteinrichtungen aus dem Netz getrennt werden. Mit weiteren Schalthandlungen können diejenigen Leitungsabschnitte des Netzes wieder mit Strom versorgt werden, die nicht vom Kurzschluss betroffen sind. Damit lässt sich im Sekundenbereich die Stromversorgung nicht betroffener Leitungsabschnitte wiederherstellen.

**Patentansprüche**

1. Verfahren zum Ermitteln eines fehlerbehafteten Abschnitts einer einseitig gespeisten Energieversorgungsleitung (10a), die durch Schalteinrichtungen (13a-d) in mehrere Abschnitte (14a-c) unterteilt ist, wobei jeder Abschnitt (14a-c) von zwei der Schalteinrichtungen (13a-d) begrenzt wird und jeder Schalteinrichtung (13a-d) eine Messeinrichtung (15a-d) zugeordnet ist, wobei

   bei dem Verfahren die folgenden Schritte durchgeführt werden:

   - jede Messeinrichtung (15a-d) erfasst an einer im Bereich der jeweiligen Schalteinrichtung (13a-d) angeordneten Messstelle (16a-d) ein Stromsignal, das einen an der jeweiligen Messstelle (16a-d) fließenden Strom angibt;
   - jede Messeinrichtung (15a-d) tastet das Stromsignal unter Bildung von Stromabtastwerten ab und ermittelt eine Strommessgröße aus den Stromabtastwerten;
   - jede Messeinrichtung (15a-d) bildet einen Deltastromwert als Differenz aus einer momentanen Strommessgröße und einer früheren Strommessgröße;
   - jede Messeinrichtung (15a-d) vergleicht den Deltastromwert mit einem Stromschwellenwert und erkennt einen Stromsprung, wenn der Deltastromwert oberhalb des Stromschwellenwertes liegt;
   - jede Messeinrichtung (15a-d) versendet eine einen Stromsprung angebende erste Statusnachricht, wenn sie einen Stromsprung erkannt hat;
   **dadurch gekennzeichnet, dass**
   - die frühere Strommessgröße eine festgelegte Anzahl von Perioden des Stromsignals vor der momentanen Strommessgröße ermittelt worden ist; und
   - eine Fehlerlokalisierungseinrichtung einen Fehler als auf demjenigen Abschnitt (14a-c) der Energieversorgungsleitung (10a) liegend erkennt, der an seinem einen Ende von einer Schalteinrichtung (13a-d) begrenzt wird, deren Messeinrichtung (15a-d) einen Stromsprung erkannt hat, und an seinem anderen Ende von einer Schalteinrichtung (13a-d) begrenzt wird, deren Messeinrichtung (15a-d) keinen Stromsprung erkannt hat, wobei die Fehlerlokalisierungseinrichtung einen Fehler als auf einem bestimmten Abschnitt (14a-c) der Energieversorgungsleitung (10a) liegend erkennt, wenn innerhalb einer maximalen Zeitdauer nach Erkennen eines Stromsprungs mit der Messeinrichtung (15a-d) an dem einen Ende des Abschnitts (14a-c) eine erste Statusnachricht der Messeinrichtung (15a-d) an dem zweiten Ende des Abschnitts (14a-c) ausbleibt.

2. Verfahren nach Anspruch 1,
   **dadurch gekennzeichnet, dass**

   - die Strommessgröße als Effektivwert oder als Grundschwingungsanteil aus den Stromabtastwerten ermittelt wird oder aus den Stromabtastwerten und zugehörigen Spannungsabtastwerten berechnet wird.

3. Verfahren nach einem der Ansprüche 1 oder 2,
   **dadurch gekennzeichnet, dass**

   - der Stromschwellenwert statisch festgelegt wird.

4. Verfahren nach einem der Ansprüche 1 oder 2,
   **dadurch gekennzeichnet, dass**

   - der Stromschwellenwert dynamisch festgelegt wird.

5. Verfahren nach Anspruch 4,
   **dadurch gekennzeichnet, dass**

   - der Stromschwellenwert dynamisch in Abhängigkeit von einem Differenzstromwert gebildet wird, der unter Verwendung einer Differenz zwischen den an beiden Enden eines Abschnitts (14a-c) der Energieversorgungsleitung (10a) ermittelten Strommessgrößen gebildet wird.

6. Verfahren nach einem der vorangehenden Ansprüche,
   **dadurch gekennzeichnet, dass**

- zur Bildung des Deltastromwertes anstelle der früheren Strommessgröße ein festgelegter Maximalwert verwendet wird, wenn die frühere Strommessgröße einen vorgegebenen Vergleichsschwellenwert übersteigt.

7. Verfahren nach Anspruch 6,
   **dadurch gekennzeichnet, dass**

   - der Vergleichsschwellenwert in Abhängigkeit von einem Differenzstromwert gebildet wird, der unter Verwendung einer Differenz zwischen den an beiden Enden eines Abschnitts (14a-c) der Energieversorgungsleitung (10a) ermittelten Strommessgrößen gebildet wird.

8. Verfahren nach einem der vorangehenden Ansprüche,
   **dadurch gekennzeichnet, dass**

   - die Fehlerlokalisierungseinrichtung Bestandteil zumindest einer der Messeinrichtungen (15a-d) ist.

9. Verfahren nach einem der Ansprüche 1 bis 7,
   **dadurch gekennzeichnet, dass**

   - die Fehlerlokalisierungseinrichtung Bestandteil einer von den Messeinrichtungen (15a-d) verschiedenen zentralen Auswertungseinrichtung (z.B. 20) ist.

10. Verfahren nach einem der vorangehenden Ansprüche,
    **dadurch gekennzeichnet, dass**

    - die Messeinrichtungen (15a-d), solange sie keinen Stromsprung erkennen, in regelmäßigen Zeitabständen eine zweite Statusnachricht versenden, die angibt, dass kein Stromsprung erkannt wurde, und
    - die Messeinrichtungen (15a-d) die erste Statusnachricht in solchen Zeitabständen wiederholen, die kleiner als die Zeitabstände sind, in denen die zweite Statusnachricht versendet wird.

11. Verfahren nach einem der vorangehenden Ansprüche,
    **dadurch gekennzeichnet, dass**

    - die Statusnachrichten als GOOSE-Nachrichten gemäß dem Standard IEC 61850 gebildet werden.

12. Verfahren nach einem der vorangehenden Ansprüche,
    **dadurch gekennzeichnet, dass**

    - die Fehlerlokalisierungseinrichtung erst dann einen Fehler als auf dem bestimmten Abschnitt (14a-c) liegend erkennt, wenn der Deltastromwert derjenigen Messeinrichtung (15a-d), die den Stromsprung erkannt hat, über einem Bestätigungsschwellenwert liegt, der in Abhängigkeit von einem Differenzstromwert gebildet wird, der unter Verwendung einer Differenz zwischen den an beiden Enden eines Abschnitts (14a-c) der Energieversorgungsleitung (10a) ermittelten Strommessgrößen gebildet wird.

13. Verfahren nach einem der vorangehenden Ansprüche,
    **dadurch gekennzeichnet, dass**

    - bei einem auf einem bestimmten Abschnitt (14a-c) der Energieversorgungsleitung (10a) erkannten Fehler unmittelbar diejenigen Schalteinrichtungen (13a-d) geöffnet werden, die diesen Abschnitt der Energieversorgungsleitung (10a) begrenzen.

14. Verfahren nach einem der Ansprüche 1 bis 12,
    **dadurch gekennzeichnet, dass**

    - bei einem auf einem bestimmten Abschnitt (14a-c) der Energieversorgungsleitung (10a) erkannten Fehler zunächst ein den Schalteinrichtungen (13a-d) einspeiseseitig vorgeordneter Leistungsschalter (13e) geöffnet wird und erst nach dem Öffnen des Leistungsschalters (13e) diejenigen Schalteinrichtungen (13a-d) geöffnet werden, die diesen Abschnitt (14a-c) der Energieversorgungsleitung (10a) begrenzen.

**15.** Verfahren nach Anspruch 14,
**dadurch gekennzeichnet, dass**

- nach dem Öffnen der den fehlerbehafteten Abschnitt (14a-c) begrenzenden Schalteinrichtungen (13a-d) der Leistungsschalter (13e) wieder geschlossen wird.

**16.** Verfahren nach Anspruch 15,
**dadurch gekennzeichnet, dass**

- nach dem Öffnen der den fehlerbehafteten Abschnitt (14a-c) begrenzenden Schalteinrichtungen (13a-d) auch ein Verbindungsschalter (12) geschlossen wird, der denjenigen Teil der Energieversorgungsleitung (10a), der an das von der Einspeisung abgewandte Ende des fehlerbehafteten Abschnitts (14a-c) angrenzt, mit einer weiteren Einspeisung verbindet.

**17.** System zum Ermitteln eines fehlerbehafteten Abschnitts einer einseitig gespeisten Energieversorgungsleitung (10a), die durch Schalteinrichtungen (13a-d) in mehrere Abschnitte (14a-d) unterteilt ist, wobei jeder Abschnitt (14a-c) von zwei der Schalteinrichtungen (13a-d) begrenzt wird, wobei das System mindestens eine Fehlerlokalisierungseinrichtung und mindestens zwei Messeinrichtungen (15a-d) aufweist, wobei
die Messeinrichtungen (15a-d) jeweils einer der Schalteinrichtungen (13a-d) zuordenbar sind,
**dadurch gekennzeichnet, dass**

- das System zur Durchführung eines Verfahrens gemäß einem der Ansprüche 1 bis 16 eingerichtet ist.

**Claims**

**1.** Method for determining a faulty section of a power supply line (10a) which is fed from one side and which is divided into a plurality of sections (14a-c) by switching devices (13a-d), wherein each section (14a-c) is delimited by two of the switching devices (13a-d) and each switching device (13a-d) has an associated measurement device (15a-d), wherein the following steps are carried out in the method:

- each measurement device (15a-d) detects a current signal at a measurement point (16a-d) which is arranged in the region of the respective switching device (13a-d), said current signal indicating a current flowing at the respective measurement point (16a-d);
- each measurement device (15a-d) samples the current signal so as to form current sample values, and determines a current measurement variable from the current sample values;
- each measurement device (15a-d) forms a delta current value as the difference between an instantaneous current measurement variable and a previous current measurement variable;
- each measurement device (15a-d) compares the delta current value with a current threshold value and identifies a jump in current when the delta current value is above the current threshold value;
- each measurement device (15a-d) sends a first status message, which indicates a jump in current, when it has identified a jump in current;
**characterised in that**
- the previous current measurement variable has been determined a fixed number of periods of the current signal before the instantaneous current measurement variable; and
- a fault location device identifies a fault as being present on that section (14a-c) of the power supply line (10a) which is delimited at one end by a switching device (13a-d) of which the measurement device (15a-d) has identified a jump in current, and is delimited at its other end by a switching device (13a-d) of which the measurement device (15a-d) has not identified a jump in current,
wherein the fault location device identifies a fault as being present on a specific section (14a-c) of the power supply line (10a) if within a maximum period after identification of a jump in current by the measurement device (15a-d) at one end of the section (14a-c) a first status message of the measurement device (15a-d) does not materialize at the second end of the section (14a-c).

**2.** Method according to claim 1,
**characterised in that**

- the current measurement variable is determined as the effective value or as the basic oscillation component from the current sample values or from the current sample values and associated voltage sample values.

3. Method according to one of claims 1 or 2,
**characterised in that**

   - the current threshold value is statically fixed.

4. Method according to one of claims 1 or 2, **characterised in that**

   - the current threshold value is dynamically fixed.

5. Method according to claim 4,
**characterised in that**

   - the current threshold value is dynamically formed as a function of a differential current value which is formed using a difference between the current measurement variables determined at the two ends of a section (14a-c) of the power supply line (10a).

6. Method according to one of the preceding claims, **characterised in that**

   - instead of the previous current measurement variable, a fixed maximum value is used to form the delta current value when the previous current measurement variable exceeds a predefined comparison threshold value.

7. Method according to claim 6,
**characterised in that**

   - the comparison threshold value is formed as a function of a differential current value which is formed using a difference between the current measurement variables determined at the two ends of a section (14a-c) of the power supply line (10a).

8. Method according to one of the preceding claims, **characterised in that**

   - the fault location device is a component of at least one of the measurement devices (15a-d).

9. Method according to one of claims 1 to 7, **characterised in that**

   - the error location device is a component of a central evaluation device (e.g. 20) different from the measurement devices (15a-d).

10. Method according to one of the preceding claims, **characterised in that**

   - the measurement devices (15a-d), if they do not identify a jump in current, send a second status message at regular intervals, and this indicates that no jump in current has been identified, and
   - the measurement devices (15a-d) repeat the first status message at intervals which are shorter than the intervals in which the second status message is sent.

11. Method according to one of the preceding claims, **characterised in that**

   - the status messages are formed as GOOSE messages according to the IEC 61850 standard.

12. Method according to one of the preceding claims, **characterised in that**

   - the fault location device only identifies a fault as being present on a certain section (14a-c) when the delta current value of the measurement device (15a-d), which identified the jump in current, lies above a confirmation threshold value, which is formed as a function of a differential current value, which is formed by using a difference between the current measurement variables determined at the two ends of a section (14a-c) of the power supply line (10a).

**13.** Method according to one of the preceding claims, **characterised in that**

- in the case of a fault identified on a certain section (14a-c) of the power supply line (10a), those switching devices (13a-d) which delimit this section of the power supply line (10a) are opened immediately.

**14.** Method according to one of claims 1 to 12,
**characterised in that**

- in the case of a fault identified on a certain section (14a-c) of the power supply line (10a), firstly a power breaker (13e) upstream of the switching devices (13a-d) on the feed side is opened and only after opening of the power breaker (13e) are those switching devices (13a-d) which delimit this section (14a-c) of the power supply line (10a) opened.

**15.** Method according to claim 14,
**characterised in that**

- after the switching devices (13a-d) delimiting the faulty section (14a-c) have been opened, the power breaker (13e) is closed again.

**16.** Method according to claim 15,
**characterised in that**

- after the switching devices (13a-d) delimiting the faulty section (14a-c) have been opened, a connection switch (12) is also closed which connects that part of the power supply line (10a), which adjoins the end of the faulty section (14a-c) remote from the feed-in, to a further feed-in.

**17.** System for determining a faulty section of a power supply line (10a) which is fed from one side and which is divided into a plurality of sections (14a-d) by switching devices (13a-d), wherein each section (14a-c) is delimited by two of the switching devices (13a-d), wherein the system has at least one fault location device and at least two measurement devices (15a-d), wherein one of the switching devices (13a-d) can be associated with the measurement devices (15a-d), **characterised in that**

- the system is set up to carry out a method according to one of claims 1 to 16.

**Revendications**

**1.** Procédé de détermination d'un tronçon défectueux d'une ligne (10a) d'alimentation en énergie alimentée d'un côté, qui est subdivisée en plusieurs tronçons (14a-c) par des dispositifs (13a-d) de coupure, dans lequel on délimite chaque tronçon (14a-c) par deux des dispositifs (13a-d) de coupure et à chaque dispositif (13a-d) de coupure est associé un dispositif (15a-d) de mesure, dans lequel
dans le procédé on effectue les stades suivants :

- chaque dispositif (15a-d) de mesure relève, à un point (16a-d) de mesure disposé dans la partie du dispositif (13a-d) respectif de coupure, un signal de courant, qui indique un courant passant au point (16a-d) de mesure ;
- chaque dispositif (15a-d) de mesure échantillonne le signal de courant en formant des valeurs d'échantillonnage de courant et détermine une grandeur de mesure de courant à partir des valeurs d'échantillonnage de courant ;
- chaque dispositif (15a-d) de mesure forme une valeur delta de courant sous la forme d'une différence entre une grandeur instantanée de mesure de courant et une grandeur antérieure de mesure de courant ;
- chaque dispositif (15a-d) de mesure compare la valeur delta de courant à une valeur de seuil de courant et détecte un saut de courant, si la valeur delta de courant est supérieure à la valeur de seuil de courant ;
- chaque dispositif (15a-d) de mesure envoie un premier message d'état, indiquant un saut de courant, s'il a détecté un saut de courant ;
**caractérisé en ce que**
- on a déterminé la grandeur antérieure de mesure de courant sur un nombre fixé de périodes du signal de courant avant la grandeur instantanée de mesure de courant et
- un dispositif de localisation de défaut détecte un défaut se trouvant sur le tronçon (14a-c) de la ligne (10a) d'alimentation en énergie, que l'on a délimité à l'une de ses extrémités par un dispositif (13a-d) de coupure, dont le dispositif (15a-d) de mesure a détecté un saut de courant et que l'on a délimité à son autre extrémité par un dispositif (13a-d) de coupure, dont le dispositif (15a-d) de mesure n'a pas détecté de saut de courant, dans lequel le dispositif de localisation de défaut détecte un défaut comme se trouvant sur un tronçon (14a-c) déterminé de la ligne (10a) d'alimentation en énergie si, dans une durée maximum après la détection d'un saut de courant par le dispositif (15a-d) de mesure à la une extrémité du tronçon (14a-c) il n'y a pas un premier message d'état du dispositif (15a-d) de mesure à la deuxième extrémité du tronçon (14a-c).

2. Procédé suivant la revendication 1, **caractérisé en ce que**

- on détermine la grandeur de mesure de courant sous la forme d'une valeur efficace ou sous la forme d'une partie d'oscillation fondamentale à partir des valeurs d'échantillonnage de courant ou on la calcule à partir des valeurs d'échantillonnage de courant et des valeurs d'échantillonnage de tension associées.

3. Procédé suivant l'une des revendications 1 ou 2, **caractérisé en ce que**

- on fixe statiquement la valeur de seuil de courant.

4. Procédé suivant l'une des revendications 1 ou 2, **caractérisé en ce que**

- on fixe dynamiquement la valeur de seuil de courant.

5. Procédé suivant la revendication 4, **caractérisé en ce que**

- on forme la valeur de seuil de courant dynamiquement en fonction d'une valeur de différence de courant, que l'on forme en utilisant une différence entre les grandeurs de mesure de courant déterminées aux deux extrémités d'un tronçon (14a-c) de la ligne (10a) d'alimentation en énergie.

6. Procédé suivant l'une des revendications précédentes, **caractérisé en ce que**

- pour former la valeur delta de courant, on utilise, au lieu de la grandeur antérieure de mesure de courant, une valeur maximum fixée, si la grandeur antérieure de mesure du courant dépasse une valeur de seuil de comparaison donnée à l'avance.

7. Procédé suivant la revendication 6, **caractérisé en ce que**

- on forme la valeur de seuil de comparaison en fonction d'une valeur de différence de courant, que l'on forme en utilisant une différence entre les grandeurs de mesure de courant déterminées aux deux extrémités d'un tronçon (14a-c) de la ligne (10a) d'alimentation en énergie.

8. Procédé suivant l'une des revendications précédentes, **caractérisé en ce que**

- le dispositif de localisation de défaut est une partie constitutive d'au moins l'un des dispositifs (15a-d) de mesure.

9. Procédé suivant l'une des revendications 1 à 7, **caractérisé en ce que**

- le dispositif de localisation de défaut est une partie constitutive d'un dispositif (par exemple 20) central d'exploitation différent des dispositifs (15a-d) de mesure.

10. Procédé suivant l'une des revendications précédentes, **caractérisé en ce que**

- les dispositifs (15a-d) de mesure, tant qu'ils ne détectent pas de saut de courant, envoient à des intervalles de temps réguliers un deuxième message d'état, qui indique qu'un saut de courant n'a pas été détecté et

- les dispositifs (15a-d) de mesure répètent le premier message d'état à des intervalles de temps, qui sont plus brefs que les intervalles de temps, dans lesquels on envoie le deuxième message d'état.

**11.** Procédé suivant l'une des revendications précédentes, **caractérisé en ce que**

- on forme les messages d'état sous la forme de messages GOOSE selon la norme IEC 61850.

**12.** Procédé suivant l'une des revendications précédentes, **caractérisé en ce que**

- le dispositif de localisation de défaut ne détecte un défaut comme se trouvant sur le tronçon (14a-c) déterminé que si la valeur delta de courant du dispositif (15a-d) de mesure, qui a détecté le saut de courant, se trouve au-dessus d'une valeur de seuil de confirmation, que l'on forme en fonction d'une valeur de différence de courant, que l'on forme en utilisant une différence entre les grandeurs de mesure de courant déterminées aux deux extrémités d'un tronçon (14a-d) de la ligne (10a) d'alimentation d'énergie.

**13.** Procédé suivant l'une des revendications précédentes, **caractérisé en ce que**,

- lorsqu'un défaut a été détecté sur un tronçon (14a-c) déterminé de la ligne (10a) d'alimentation en énergie, on ouvre immédiatement les dispositifs (13a-d) de coupure, qui délimitent ce tronçon de la ligne (10a) d'alimentation en énergie.

**14.** Procédé suivant l'une des revendications 1 à 12, **caractérisé en ce que**,

- lorsqu'un défaut a été détecté sur un tronçon (14a-c) déterminé de la ligne (10a) d'alimentation en énergie, on ouvre d'abord un interrupteur (13e) de puissance, monté en amont du côté de l'alimentation des dispositifs (13a-d) de coupure et on ouvre, seulement après l'ouverture de l'interrupteur (13e) de puissance, les dispositifs (13a-d) de coupure, qui délimitent ce tronçon (14a-c) de la ligne (10a) d'alimentation en énergie.

**15.** Procédé suivant la revendication 14, **caractérisé en ce que**,

- après l'ouverture des dispositifs (13a-d) de coupure délimitant le tronçon (14a-c) défectueux, on referme l'interrupteur (13e) de puissance.

**16.** Procédé suivant la revendication 5, **caractérisé en ce que**,

- après l'ouverture des dispositifs (13a-d) de coupure délimitant le tronçon (14a-c) défectueux, on ferme également un interrupteur (12) de liaison qui relie la partie de la ligne (10a) d'alimentation en énergie, qui est voisine de l'extrémité éloignée de l'alimentation du tronçon (14a-c) défectueux, à une autre alimentation.

**17.** Système de détermination d'un tronçon défectueux d'une ligne (10a) d'alimentation en énergie alimentée d'un côté, qui est subdivisée en plusieurs tronçons (14a-d) par des dispositifs (13a-d) de coupure, dans lequel chaque tronçon (14a-c) est délimité par deux des dispositifs (13a-d) de coupure, dans lequel le système a au moins un dispositif de localisation de défaut et au moins deux dispositifs (15a-d) de mesure, dans lequel les dispositifs (15a-d) de mesure peuvent chacun être associés à l'un des dispositifs (13a-d) de coupure, **caractérisé en ce que**

- le système est conçu pour effectuer un procédé suivant l'une des revendications 1 à 16.

# FIG 1

FIG 2

20

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007020955 B4

- EP 0554553 B1